# EUROPEAN PATENT APPLICATION

(11) **EP 3 951 865 A1**
(43) Date of publication of application: **09.02.2022**
(21) Application number: 20777364.9
(22) Date of filing: 27.03.2020
(51) Int. Cl.: H01L 23/473, H01M 10/613, H01M 10/625, H01M 10/643, H01M 10/647, H01M 10/651, H01M 10/653, H01M 10/6551, H05K 7/20

(54) **COOLING UNIT, COOLING DEVICE, BATTERY STRUCTURE, AND ELECTRIC VEHICLE**

(30) Priority: 28.03.2019 JP 2019062787
(71) Applicant: Mitsui Chemicals, Inc., Tokyo 105-7122 (JP)
(72) Inventor: TORII, Tomoki, Tokyo 105-7122 (JP); NOMOTO, Kyohei, Tokyo 105-7122 (JP)
(74) Representative: J A Kemp LLP
(86) International application number: PCT/JP2020/014236
(87) International publication number: WO 2020/196878

(57) **Abstract**

A cooling unit includes a structure in which a box body made of resin and a plate lid made of metal are bonded together, in which at least one of an upper surface and a lower surface of the box body has an opening and the plate lid is bonded with the box body so as to block the opening, a wall surface of the box body is provided with a refrigerant inlet and a refrigerant outlet for allowing a refrigerant to flow in the box body, a flow path-forming rib is provided in the box body, and a part or an entirety of the box body is formed of a fiber-reinforced resin and/or a resin containing an inorganic particle filler.

## Description

### TECHNICAL FIELD

The present invention relates to a cooling unit, a cooling apparatus, a battery structure, and an electric vehicle.

### BACKGROUND ART

In recent years, the miniaturization of electronic devices and secondary battery modules has progressed rapidly. Accordingly, there is a tendency for the amount of heat generated per unit volume (or unit area) to increase. Thus, the importance of heat management is increasing.

Heat generation leads to a rise in the temperature of the device body or the battery body. Semiconductor devices, which play a central role in the operations inside electronic devices, are extremely sensitive to temperature. Thus, an increase in the temperature of the devices leads to a decrease in operating efficiency, malfunctions, and failures. In addition, even in a secondary battery, a high heat state exceeding the upper limit value of the operating temperature range may cause capacity deterioration and an increase in internal resistance. When the battery is left as is in a high temperature state, there is also a possibility of causing a battery explosion or the like. Accordingly, cooling techniques for heat management are important.

In order to cool heating elements such as electronic devices and secondary battery modules, "cooling units", which perform cooling by causing a liquid refrigerant to flow in the inner portion thereof, are being developed.

As an example, Patent Document 1 describes a battery block provided with a cooling plate (cooling unit) which extends in the direction of an array of a plurality of battery cells and contacts one surface of each battery cell either directly or through a heat-conductive layer.

As another example, Patent Document 2 describes a power conversion apparatus provided with a semiconductor module in which a plurality of semiconductor elements for power conversion are mounted and a cooling case (cooling unit) having a cooling liquid for cooling the semiconductor module.

### RELATED DOCUMENT

### PATENT DOCUMENT

[Patent Document 1] Japanese Unexamined Patent Publication No. 2016-029624
[Patent Document 2] Japanese Unexamined Patent Publication No. 2001-308246

### SUMMARY OF THE INVENTION

### TECHNICAL PROBLEM

In the related art, cooling units were mainly formed of metal members from the viewpoint of thermal conductivity. However, since metal is heavy, reducing the weight of the cooling unit by replacing some of the metal members with resin members may be considered.

However, in the findings of the present inventors, when simply replacing some of the metal members with resin members of the same shape, there may be a problem in that the strength is weaker than that of the metal. For example, in a case where the portion in which the refrigerant flows is made of a resin member, there may be a problem in that the pressure when the refrigerant flows through the resin member may cause the resin member portion to deform (specifically, the resin member may "expand" due to the pressure of the refrigerant in the inner portion) . In addition, there is also a problem in that resin members are weaker against impact in comparison with the case of metal members and it is necessary to somehow improve the impact resistance of resin members, in particular, in a case of being used in a field where there is a demand for impact resistance.

The present invention was created in consideration of these circumstances. Objects of the present invention are to suppress deformation of a resin member caused by pressure when a refrigerant flows and to improve impact resistance in a cooling unit in which a resin member is used.

### SOLUTION TO PROBLEM

As a result of intensive studies, the present inventors completed the invention provided below, thereby solving the problems described above.

The present invention is as follows.

1. A cooling unit including a structure in which a box body made of resin and a plate lid made of metal are bonded together, in which at least one of an upper surface and a lower surface of the box body has an opening and the plate lid is bonded with the box body so as to block the opening, a wall surface of the box body is provided with a refrigerant inlet and a refrigerant outlet for allowing a refrigerant to flow in the box body, a flow path-forming rib is provided in the box body, and a part or an entirety of the box body is formed of a fiber-reinforced resin and/or a resin containing an inorganic particle filler.
2. The cooling unit according to 1., in which a fiber included in the fiber-reinforced resin are at least one selected from the group consisting of a carbon fiber, a glass fiber, a potassium titanate fiber, an aluminum borate fiber, a ceramic fiber, a metal fiber, a boron fiber, a silicon carbide fiber, an asbestos fiber, a rock wool fiber, an aramid fiber, a polyethylene fiber, a polypara-phenylene benzobisoxazole fiber, and a cellulose fiber, and the inorganic particle filler is at least one selected from the group consisting of mica, talc, and glass flakes.
3. The cooling unit according to 1. or 2., in which the flow path-forming rib is integrally molded with the box body.
4. The cooling unit according to 1. or 2., in which the flow path-forming rib is formed separately from the box body by a resin which is neither a fiber-reinforced resin nor a resin containing an inorganic particle filler and bonded in the box body formed of the fiber-reinforced resin and/or the resin containing an inorganic particle filler.
5. The cooling unit according to 4., in which a part of the flow path-forming rib covers an upper end portion of the box body in a flange shape and the plate lid is bonded with the box body through a flange shaped portion of the flow path-forming rib.
6. The cooling unit according to any one of 1. to 5., in which the metal forming the plate lid is at least one selected from the group consisting of aluminum, copper, magnesium, and an alloy thereof.
7. The cooling unit according to any one of 1. to 6., in which a fine uneven structure and/or a thin film layer containing a functional group is formed on a bonding surface of the plate lid with the box body.
8. The cooling unit according to 7., in which an average pore diameter of a concave portion in the fine uneven structure is 5 nm to 250 µm and an average pore depth of the concave portion is 5 nm to 250 µm.
9. The cooling unit according to 7. or 8., in which the functional group is at least one selected from the group consisting of a hydroxyl group, a silanol group, a mercapto group, a thiocarbonyl group, a cyano group, an isocyanate group, an amino group, an ammonium group, a pyridinium group, an azinyl group, a carboxyl group, a benzotriazole group, and a triazinethiol group.
10. The cooling unit according to any one of 1. to 9., in which the box body and the plate lid are directly bonded with each other without an intermediate layer.
11. The cooling unit according to any one of 1. to 9., in which the box body and the plate lid are bonded with each other through an intermediate layer.
12. The cooling unit according to any one of 1. to 11., in which the box body and the plate lid are fixed by a rivet and/or a screw.
13. The cooling unit according to any one of 1. to 12., in which a resin sealing member is provided so as to cover a bonding portion between the box body and the plate lid.
14. A cooling apparatus including the cooling unit according to any one of 1. to 13., and an object to be cooled that is thermally connected to an upper surface of the plate lid of the cooling unit.
15. The cooling apparatus according to 14., in which the object to be cooled is at least one selected from the group consisting of an electronic component, a lamp, a battery, and a superconducting material.
16. The cooling apparatus according to 14. or 15., further including a sensor for sensing leakage of a refrigerant from a bonding interface between the box body and the plate lid, in which the sensor is provided with a unit for wired or wireless connection to a leak detection module for notifying a user and/or an administrator of the cooling apparatus of an abnormality.
17. A battery structure including a battery block in which two or more battery cells are arranged adjacent to each other in close contact or at an interval, and the cooling unit according to any one of 1. to 13., in which the battery block is arranged on the plate lid in the cooling unit.
18. An electric vehicle including the battery structure according to 17., in which the battery structure is covered by a housing, either as one battery structure or two or more connected battery structures.

### ADVANTAGEOUS EFFECTS OF INVENTION

According to the present invention, in a cooling unit in which a resin member is used, deformation of the resin member due to pressure when a refrigerant flows is suppressed and excellent impact resistance is obtained.

### BRIEF DESCRIPTION OF THE DRAWINGS

Fig. 1 is a schematic diagram to illustrate a first embodiment.
Fig. 2 is a schematic diagram to illustrate a second embodiment.
Fig. 3 is a schematic diagram to illustrate a third embodiment.
Fig. 4 is a schematic diagram to illustrate a fourth embodiment.
Fig. 5 is a schematic diagram to illustrate a fifth embodiment.
Fig. 6 is a schematic diagram to illustrate a sixth embodiment.
Fig. 7 is a schematic diagram to illustrate a form of a cooling apparatus (battery structure).

### DESCRIPTION OF EMBODIMENTS

A detailed description will be given below of the embodiments of the present invention with reference to the drawings.

In all drawings, similar constituent components are denoted by the same reference numerals and description thereof will not be repeated as appropriate.

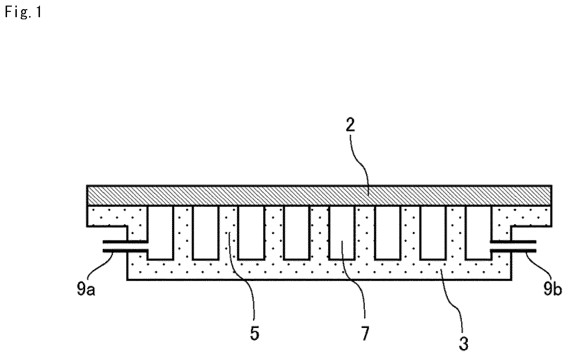

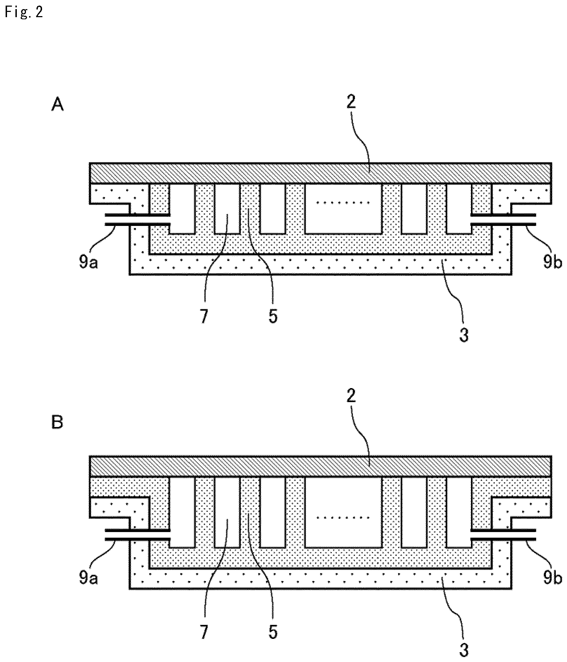

In order to avoid complications, (i) in a case where there are a plurality of identical constituent components in the same drawing, only one thereof, and not all thereof, may be denoted by a reference numeral, (ii) in particular, in Fig. 2 and beyond, the same constituent components as in Fig. 1 may not be denoted by reference numerals again.

All drawings are for illustrative purposes only. The shapes, dimensional ratios, and the like of each member in the drawings do not necessarily correspond to those of the actual articles.

In the present specification, the notation "a to b" in a description of numerical ranges indicates "a" or more and "b" or less, unless otherwise specified.

For example, "1% by mass to 5% by mass" means "1% by mass or more and 5% by mass or less".

A description will be given below of several embodiments of the present invention.

In the description of the second and subsequent embodiments, points which are in common with the first embodiment will not be repeated as appropriate.

### <First Embodiment>

Fig. 1 is a schematic diagram (schematic cross-sectional diagram) for illustrating the structure of a cooling unit of the first embodiment.

The cooling unit of the first embodiment includes a plate lid made of metal (a plate lid 2) and a box body made of resin (a box body 3). The upper surface of the box body 3 has an opening and the plate lid 2 is bonded with the box body 3 so as to block the opening. To confirm, "bonded" specifically means that the plate lid 2 and the box body 3 are fixed to each other such that almost no or absolutely no refrigerant leaks from a portion between the plate lid 2 and the box body 3.

The wall surface of the box body 3 (typically the wall surface of a side section) is provided with a refrigerant inlet 9a and a refrigerant outlet 9b for allowing a refrigerant to flow in an inner portion of the box body 3.

Ribs for forming a refrigerant flow path (flow path-forming ribs 5) are provided in the inner portion of the box body 3. The flow path of the refrigerant (a flow path 7) is formed by the flow path-forming ribs 5. Although not shown in the diagrams, the flow path 7 connects the refrigerant inlet 9a with the refrigerant outlet 9b. In other words, when refrigerant is introduced into the box body 3 through the refrigerant inlet 9a, the refrigerant passes through the flow path 7 and is discharged from the refrigerant outlet 9b.

In the first embodiment, the flow path-forming ribs 5 are preferably integrally molded with the box body 3. In other words, when the box body 3 is formed from the melted or softened resin material, the flow path-forming ribs 5 are also preferably formed at the same time. In the first embodiment, there is preferably no "seam" between the flow path-forming ribs 5 and the box body 3.

In the cooling unit of the first embodiment, in particular, a part or an entirety of the box body 3 is formed of a fiber-reinforced resin and/or a resin containing an inorganic particle filler. Due to this, it is possible to improve the strength of the box body 3 to be greater than when the entire box body 3 is formed of a resin which is neither a fiber-reinforced resin nor a resin containing an inorganic particle filler. Then, deformation of the resin member (for example, swelling of the box body 3 or the like) due to the pressure when the refrigerant flows is suppressed, and furthermore, the impact resistance is increased.

A fiber-reinforced resin is usually a composite material obtained by mixing fibers, such as carbon fibers and glass fibers, described below, with a resin. The resin may be a thermoplastic resin or a thermosetting resin.

Examples of thermoplastic resins include polyolefin-based resins, polyolefin-based resins containing polar groups, polymethacrylic-based resins such as polymethyl methacrylate resin, polyacrylic-based resins such as methyl polyacrylate resin, polystyrene resins, polyvinyl alcohol-polyvinyl chloride copolymer resins, polyvinyl acetal resins, polyvinyl butyral resins, polyvinyl formal resins, polymethylpentene resins, maleic anhydride-styrene copolymer resins, polycarbonate resins, polyphenylene ether resins, aromatic polyetherketones such as polyether ether ketone resin and polyether ketone resin, polyester-based resins, polyamide-based resins, polyamide-imide resins, polyimide resins, polyetherimide resins, styrene-based elastomers, polyolefin-based elastomers, polyurethane-based elastomers, polyester-based elastomers, polyamide-based elastomers, ionomers, aminopolyacrylamide resins, isobutylene maleic anhydride copolymers, ABS, ACS, AES, AS, ASA, MBS, ethylene-vinyl chloride copolymers, ethylene-vinyl acetate copolymers, ethylene-vinyl acetate-vinyl chloride graft polymers, ethylene-vinyl alcohol copolymers, chlorinated polyvinyl chloride resins, chlorinated polyethylene resins, chlorinated polypropylene resins, carboxyvinyl polymers, ketone resins, amorphous copolyester resins, norbornene resins, fluoroplastics, polytetrafluoroethylene resins, fluorinated ethylene polypropylene resins, PFA, polychlorofluoroethylene resins, ethylene tetrafluoroethylene copolymers, polyvinylidene fluoride resins, polyvinyl fluoride resins, polyarylate resins, thermoplastic polyimide resins, polyvinylidene chloride resins, polyvinyl chloride resins, polyvinyl acetate resins, polysulfone resins, polyparamethylstyrene resins, polyarylamine resins, polyvinyl ether resins, polyphenylene oxide resins, polyphenylene sulfide (PPS) resins, polymethylpentene resins, oligoester acrylate, xylene resin, maleic acid resins, polyhydroxybutyrate resins, polysulfone resins, polylactic acid resins, polyglutamic acid resins, polycaprolactone resins, polyethersulfone resins, polyacrylonitrile resins, styrene-acrylonitrile copolymer resins, and the like.

One type of thermoplastic resin may be used alone, or two or more types may be used in combination.

Examples of thermosetting resins include phenol resins, epoxy resins, unsaturated polyester resins, diallyl phthalate resins, melamine resins, oxetane resins, maleimide resins, urea resins, polyurethane resins, silicone resins, resins having benzoxazine rings, cyanate ester resins, and the like.

Among the above, from the viewpoint of heat resistance, processability, mechanical properties, adhesiveness, corrosion resistance, and the like, it is possible to suitably use one or more selected from the group consisting of phenol resins, epoxy resins, and unsaturated polyester resins.

One type of thermosetting resin may be used alone, or two or more types may be used in combination.

It is possible to use any fibers as long as it is possible to improve the strength of the box body 3. In addition, after comprehensively determining the balance of cost, strength, and the like, the fibers mixed into the fiber-reinforced resin may be one type alone, or two or more types may be combined and mixed into the resin. For example, it is also possible to mix glass fibers, which are low in cost, and carbon fibers, which are high in strength.

Preferable examples of fibers include carbon fibers, glass fibers, potassium titanate fibers, aluminum borate fibers, ceramic fibers, metal fibers, boron fibers, silicon carbide fibers, asbestos fibers, rock wool fibers, aramid fibers, polyethylene fibers, poly-paraphenylenebenzobisoxazole fibers, cellulose fibers, and the like.

The length, diameter, and the like of the fibers are also not particularly limited as long as it is possible to improve the strength of the box body 3.

It is possible to use any inorganic particle filler as long as it is possible to improve the strength of the box body 3. In addition, after comprehensively determining the balance of cost, strength, and the like, the fibers mixed into the fiber-reinforced resin may be one type alone, or two or more types may be combined and mixed into the resin.

The inorganic particle filler is preferably at least one selected from the group consisting of mica, talc, and glass flakes.

The shape and particle diameter of the inorganic particle filler are not particularly limited as long as it is possible to improve the strength of the box body 3.

One type of fiber and/or inorganic particle filler may be used alone, or two or more types may be used in combination.

The content of the fibers and/or inorganic particle filler in the fiber-reinforced resin is preferably 1 part by mass to 100 parts by mass with respect to 100 parts by mass of the resin, more preferably 5 parts by mass to 90 parts by mass, and even more preferably 10 parts by mass to 80 parts by mass.

The fiber-reinforced resin and/or the resin containing an inorganic particle filler may include various components in addition to the thermoplastic resin or thermosetting resin and fibers. For example, plasticizers, flow modifiers, mold release agents, and the like may be included.

A part of the box body 3 may be formed of a resin which is not a fiber-reinforced resin and/or a resin containing an inorganic particle filler. For example, in terms of a combination of cost and deformation suppression, portions which are particularly easily deformed due to the pressure when the refrigerant flows may be formed of a fiber-reinforced resin and/or a resin containing an inorganic particle filler, and the other portions may be formed of a resin which is neither a fiber-reinforced resin nor a resin containing an inorganic particle filler.

As the "resin which is neither a fiber-reinforced resin nor a resin containing an inorganic particle filler", for example, it is possible to use a resin from which the fibers and/or the inorganic particle filler are removed, from among the fiber-reinforced resins and/or the resin containing an inorganic particle filler described above.

The size (height and width) of the box body 3, the thickness of the side walls and bottom of the box body 3, and the like are not limited. It is possible to carry out adjustment as appropriate based on a comprehensive determination of strength sufficiency (resistance to deformation), weight reduction, cost, and the like, taking into account the product or the like in which the cooling unit will be installed. For example, in a case where the cooling unit is used in an electric automobile, the height of the box body 3 including the flow path 7 is approximately 2 mm to 20 mm. From the viewpoint of ensuring strength and cost, 5 mm to 10 mm is preferable.

In addition, it is possible to make the side walls and bottom of the box body 3 different thicknesses by design.

The method for molding the box body 3 is not particularly limited. Examples of molding methods include injection molding, extrusion molding, heat press molding, compression molding, transfer molding, pour molding, laser welding molding, reaction injection molding (RIM molding), liquid injection molding (LIM molding), spray molding, and the like. Among the above, an injection molding method is preferable from the viewpoint of productivity and quality stability.

To confirm, in a case where the flow path-forming ribs 5 are integrally molded with the box body 3, the flow path-forming ribs 5 are basically formed of the same material as the box body 3.

In addition, when the box body 3 is molded, it is also possible to integrally mold the refrigerant inlet 9a and/or the refrigerant outlet 9b.

Naturally, after the box body 3 is molded, the refrigerant inlet 9a and/or the refrigerant outlet 9b may be provided by machining or the like.

The metal forming the plate lid 2 is not particularly limited. The metal is appropriately selected from the viewpoint of heat dissipation, durability, cost, and the like. As an example, the metal forming the plate lid 2 is preferably at least one selected from the group consisting of aluminum, copper, magnesium, and alloys thereof.

The average thickness of the plate lid 2 is, for example, 0.5 mm to 30 mm, and preferably 0.5 mm to 20 mm. It is possible to appropriately adjust the thickness, taking into account heat transfer properties, strength, lightness, and the like.

The plate lid 2 and the box body 3 may be bonded through an intermediate layer or may be directly bonded without an intermediate layer. A description will be given below of the form in which the plate lid 2 and the box body 3 are bonded through an intermediate layer, in particular, as the third embodiment.

Preferably, a fine uneven structure and/or a thin film layer containing functional groups is formed in the plate lid 2 on the bonding surface with the box body 3. Due to this, it is possible to increase the bonding strength between the plate lid 2 and the box body 3 and it is expected that this will make it hard for the refrigerant to leak from the portion between the plate lid 2 and the box body 3.

As long as the cooling unit functions sufficiently and there is no significant effect on the appearance, the fine uneven structure and/or thin film layer containing functional groups may also be present in portions of the plate lid 2 other than the bonding surface with the box body 3.

Forming the fine uneven structure in the plate lid 2 on the bonding surface with the box body 3 makes it possible to, for example, increase the bonding strength when bonding the plate lid 2 and the box body 3 with an adhesive. This is because the adhesive penetrates the fine uneven structure and the so-called "anchor effect" of adhesion is easily expressed.

In the same manner, in a case where a part of the box body 3 is melted by heat or light to be bonded with the plate lid 2, the melted resin penetrates the fine uneven structures of the metal to express the anchor effect and make it possible to increase the bonding strength.

The average pore diameter of the concave portion in the fine uneven structure is preferably 5 nm to 250 µm and the average pore depth of the concave portion is preferably 5 nm to 250 µm.

It is possible to determine the average pore diameter, for example, by photographing the fine uneven structure portion with a microscope and averaging the pore diameters of 50 or more (preferably 100) of the pores confirmed in the photographed image. In a case where it is not possible to regard the shape of the pores as a perfect circle, the circle equivalent diameter is used as the pore diameter.

As the average pore depth of the concave portion, it is possible to adopt the ten-point average roughness Rzⱼᵢₛ measured in accordance with JIS B 0601.

The method for forming the fine uneven structure is not particularly limited.

Examples thereof include a method of immersing the plate lid 2 in an aqueous solution of an inorganic base such as sodium hydroxide and/or an aqueous solution of an inorganic acid such as hydrochloric acid or nitric acid; a method of treating the plate lid 2 with the anodic oxidation method; a method of forming a fine uneven structure on the surface of the plate lid 2 by pressing a die punch having unevenness formed by mechanical cutting, such as diamond abrasive grinding or blast processing, on the surface of the plate lid 2; a method of forming a fine uneven structure on the surface of the plate lid 2 by sandblasting, knurling processing, or laser processing; a method of immersing the plate lid 2 in an aqueous solution of one or more types selected from hydrazine hydrate, ammonia, and water-soluble amine compounds, as disclosed in WO2009/31632; and the like.

A thin film layer containing functional groups is formed in the plate lid 2 on the bonding surface with the box body 3, which also makes it possible to increase the bonding strength between the plate lid 2 and the box body 3. Generally, resin and metal do not adhere well to each other; however, forming a thin film layer containing functional groups on the plate lid 2 made of metal makes it possible to increase the bonding strength between the plate lid 2 and the box body 3.

Examples of the "functional groups" in the thin film layer containing functional groups include a hydroxyl group, a silanol group, a mercapto group, a thiocarbonyl group, a cyano group, an isocyanate group, an amino group, an ammonium group, a pyridinium group, an azinyl group, a carboxyl group, a benzotriazole group, a triazinethiol group, and the like.

The thin film layer containing functional groups may include only one type of functional group or may include two or more types of functional groups.

It is possible to provide the thin film layer containing functional groups using any material and any method. For example, it is possible to provide a thin film layer containing functional groups by coating a resin composition including at least one of the functional groups described above on the plate lid 2. Alternatively, it is also possible to provide a thin film layer containing functional groups by reacting a suitable coupling agent (such as a silane coupling agent) on the surface of the plate lid 2. Alternatively, a thin film layer containing functional groups may be provided using a suitable primer composition. The thickness of the thin film layer containing functional groups is not particularly limited as long as it is possible to obtain the effect of providing the thin film layer containing functional groups.

An adhesive may be used to bond the plate lid 2 and the box body 3. In a case where an adhesive is used, the usable adhesives, the method of coating the adhesives, and the like are not particularly limited. The adhesive may be in solid form or liquid form (including paste form). As adhesives, it is possible to use known natural adhesives and synthetic adhesives, one-component type and two-component types, or the like, without any particular limitations. The specific type of adhesive to be used may be selected according to the performance required for the cooling unit, the heat resistance, the materials of the plate lid 2 and box body 3, and the like.

The average thickness of the adhesive layer is, for example, 0.5 µm to 5000 µm, preferably 1.0 µm to 2000 µm, and more preferably 10 µm to 1000 µm. By setting the average thickness to the lower limit value above or more, the resin layer and the metal layer express sufficient adhesive strength, and by setting the average thickness to the upper limit value above or less, it is possible to minimize the amount of residual strain generated during the curing reaction.

The bonding conditions vary depending on the type of adhesive, but examples thereof include conditions of approximately 0.1 minutes to 7 days at room temperature to 150°C. The adhesion may be performed under pressure. In such a case, the pressure is, for example, approximately 0.01 MPa to 1 MPa.

When bonding the plate lid 2 and the box body 3, it is preferable to subject the plate lid 2 to a degreasing treatment in order to increase the bonding strength.

In particular, it is also preferable to apply the techniques described in Japanese Unexamined Patent Publication No. 2012-223991, the techniques described in Japanese Unexamined Patent Publication No. 2018-34351, and the like, as bonding techniques for the plate lid 2 made of metal and the box body 3 formed of a fiber-reinforced resin and/or a resin containing an inorganic particle filler.

### <Second Embodiment>

Fig. 2A is a schematic diagram (schematic cross-sectional diagram) to illustrate the structure of the cooling unit of the second embodiment.

In the cooling unit of Fig. 2A, flow path-forming ribs 5 are typically formed separately from the box body 3 by a resin which is neither a fiber-reinforced resin nor a resin containing an inorganic particle filler and are bonded (for example, embedded) inside the box body 3 formed by a fiber-reinforced resin and/or a resin containing an inorganic particle filler. In particular, in this respect, the cooling unit of Fig. 2A is different from the cooling unit of Fig. 1.

There is little need to form the flow path-forming ribs 5 with fiber-reinforced resin and/or resin containing an inorganic particle filler in order to suppress "swelling" of the box body 3 due to the pressure when the refrigerant flows. By forming the box body 3 with a fiber-reinforced resin and/or a resin containing an inorganic particle filler and forming the flow path-forming ribs 5 with a resin which is neither a fiber-reinforced resin nor a resin containing an inorganic particle filler, it is possible to reduce the usage amount of relatively expensive fiber-reinforced resin and/or resin containing an inorganic particle filler, while being able to obtain a sufficient deformation suppression effect.

In addition, since fiber-reinforced resins and/or resins containing an inorganic particle filler are slightly heavier than ordinary resins, forming the flow path-forming ribs 5 with a resin which is neither a fiber-reinforced resin nor a resin containing an inorganic particle filler makes it easier to further reduce the weight.

Furthermore, in a case where the structure of the flow path-forming ribs 5 (that is, the structure of the flow path) is complex, it may be difficult to integrally mold the box body 3 and the flow path-forming ribs 5 in a single time of molding. However, forming the flow path-forming ribs 5 separately from the box body 3 may make it easier to form the flow path-forming ribs 5 with a complex structure.

Fig. 2B is a schematic diagram to illustrate a Modified Example of the second embodiment.

The cooling unit of Fig. 2B is similar to that of Fig. 2A. However, there is a difference from Fig. 2A in that a part of the flow path-forming ribs 5 covers the upper end portion of the box body 3 in a flange shape and the plate lid 2 is bonded with the box body 3 through the flange shaped portion of the flow path-forming ribs 5. By designing the cooling unit in this manner, in a case where the flow path-forming ribs 5 are formed separately from the box body 3, it is possible to increase the fixation of the flow path-forming ribs 5 (position shifting of the flow path-forming ribs 5, which are members separate to the box body 3, due to external impact, refrigerant pressure, or the like, is suppressed).

### <Third Embodiment>

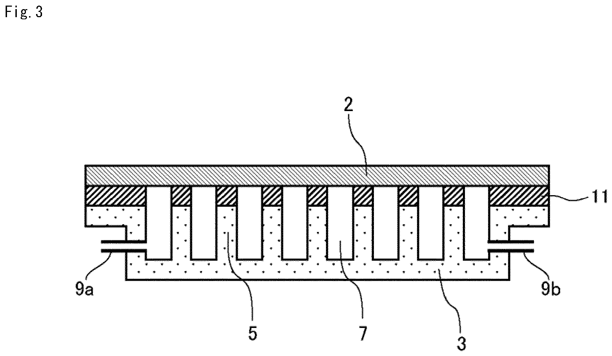

Fig. 3 is a schematic diagram (schematic cross-sectional diagram) to illustrate the structure of the cooling unit of the third embodiment. The cooling unit of the third embodiment is different from the cooling unit of the first embodiment in that the plate lid 2 and the box body 3 are bonded through an intermediate layer 11. The presence of the intermediate layer 11 tends to reduce the possibility of refrigerant leakage and to make it easier to bond the plate lid 2 and the box body 3. In addition, in a case where the fiber-reinforced resin and/or resin containing an inorganic particle filler includes an electrically conductive resin and/or filler (for example, carbon fiber), since the fiber and/or filler are able to conduct electricity by directly contacting the metal, this embodiment is particularly preferable in a case where insulation is required.

Preferably, the intermediate layer 11 is injection bonded or adhesive bonded with the plate lid 2. "Injection bonded" refers to a bonded state in which a metal member is inserted into a mold, resin is injected therein, and the two are integrated, while "adhesive bonded" is defined as a bonded state in which a metal surface and a resin surface are bonded by a chemical or physical force or both through the medium of an adhesive.

As an example, the intermediate layer 11 is formed of a material including a thermoplastic elastomer (TPE).

Among these TPEs, from the viewpoint of adhesive strength, sealing characteristics, flexibility, and the like, it is more preferable to include a urethane-based TPE (also referred to below as TPU) and an amide-based TPE (also referred to below as TPAE).

The content of TPE in the intermediate layer 11 is, for example, 60% by mass to 100% by mass or less, and preferably 65% by mass to 99% by mass. The intermediate layer 11 preferably includes both a TPU and the TPAE described above. The total content of TPU and TPAE in the intermediate layer 11 is, for example, 60% by mass to 100% by mass, preferably 65% by mass to 95% by mass, and more preferably 70% by mass to 95% by mass. By having a total content of TPU and TPAE in the intermediate layer 11 of 60% by mass or more, the intermediate layer 11 has moderate elasticity, which makes it possible to further reduce the possibility of refrigerant leakage.

The content of TPU in the intermediate layer 11 is, for example, 70% by mass to 100% by mass, preferably 70% by mass to 99% by mass, and more preferably 75% by mass to 98% by mass or less. On the other hand, the content of TPAE is, for example, 0% by mass to 30% by mass, preferably 1% by mass to 30% by mass, and more preferably 2% by mass to 25% by mass. By appropriately setting these values, corrosion caused by the refrigerant is suppressed and elasticity and the like are improved.

TPU is, for example, a multi-block polymer formed of a hard segment formed of diisocyanate and a short chain glycol (chain extender) and a soft segment mainly formed of a polymer glycol having a number average molecular weight of approximately 1000 to 4000. Examples of the diisocyanate include aromatic isocyanates typified by 4,4'-diphenylmethane diisocyanate (MDI) and the like. Aliphatic isocyanates such as hexamethylene diisocyanate (HDI) or the like are also appropriately used in applications requiring weather resistance. Examples of short chain glycols include ethylene glycol, 1,3-propanediol, 1,4-butanediol, 1,6-hexanediol, diethylene glycol, tetraethylene glycol, neopentyl glycol, 1,4-cyclohexanedimethanol, mixtures thereof, and the like. Examples of the polymer glycol include a polyether polyol typified by polytetramethylene ether glycol (PTMEG), a polyester polyol which is a condensation type polymer of adipic acid and an aliphatic or aromatic glycol, a polycaprolactone polyol obtained by ring-opening polymerization of ε-caprolactone, and the like.

Depending on what kind of components are used as the diisocyanate component, the short chain glycol, and the polymer glycol, the TPU is classified into an ether type, an adipate ester type, a caprolactone type, a carbonate type, or the like; however, in the present embodiment, it is possible to use the TPUs described above without limitation.

It is possible to use commercial products as the TPU. Examples thereof include RESAMINE P (trademark) of Dainichiseika Color & Chemicals Mfg. Co., Ltd., PANDEX (trademark) of DIC Covestro Polymer Ltd., MIRACTRAN (trademark) of Tosoh Corporation, PELLETHANE (trademark) of Dow Chemical Company, ESTANE (trademark) of B.F. Goodrich Corporation, DESMOPAN (trademark) of Bayer, and the like.

TPAE means that there is an amide bond (-CONH-) in the polymer main chain forming the hard segment. Examples of TPAE include an amide-based thermoplastic elastomer (TPA) defined in JIS K6418: 2007 or the like and a polyamide-based elastomer described in Japanese Unexamined Patent Publication No. 2004-346273 or the like.

Examples of TPAE include a material in which at least polyamide forms a hard segment having crystallinity and a high melting point while another polymer (for example, polyester, polyether, or the like) forms a soft segment having amorphousness and a low glass transition temperature. In addition, in the TPAE, a structure derived from a chain length extender such as a dicarboxylic acid may be included in addition to the hard segment and the soft segment.

Examples of the polyamide forming the hard segment include a polyamide produced by ring-opening polycondensation of ω-aminocarboxylic acid such as 6-aminocaproic acid and a lactam such as ε-caprolactam.

In addition, examples of the polymer forming the soft segment include polyester and polyether, examples of the polyether include polyethylene glycol, polypropylene glycol, polytetramethylene ether glycol, an ABA-type triblock polyether, and the like, and it is possible to use these alone or in a combination of two or more types.

In addition, it is possible to use a polyether diamine or the like obtained by reacting ammonia or the like with the terminal of the polyether.

Examples of the combinations of the hard segment and the soft segment include each combination of the hard segment and the soft segment exemplified above. Among these, a combination of lauryl lactam ring-opening polycondensate/polyethylene glycol, a combination of lauryl lactam ring-opening polycondensate/polypropylene glycol, a combination of lauryl lactam ring-opening polycondensate/polytetramethylene ether glycol, and a combination of lauryl lactam ring-opening polycondensate/ABA-type triblock polyether are preferable, and a combination of lauryl lactam ring-opening polycondensate/ABA-type triblock polyether is particularly preferable.

As commercial products of TPAE, it is possible to use Pebax 33 series of Arkema (for example, 7233, 7033, 6333, 5533, 4033, MX1205, 3533, and 2533), "UBESTA XPA" series of Ube Industries, Ltd. (for example, XPA9063X1, XPA9055X1, XPA9048X2, XPA9048X1, XPA9040X1, XPA9040X2, and the like), "Vestamid" series of Daicel Evonik Ltd. (for example, E40-S3, E47-S1, E47-S3, E55-S1, E55-S3, EX9200, and E50-R2), and the like.

The intermediate layer 11 preferably further includes an acid-modified polymer. The content of the acid-modified polymer in the intermediate layer 11 is preferably 1 part by mass to 35 parts by mass with respect to a total of 100 parts by mass of the TPU and the TPAE, and more preferably 3 parts by mass to 30 parts by mass, and even more preferably 5 parts by mass to 25 parts by mass.

In the findings of the present inventors, including the acid-modified polymer in the intermediate layer 11 significantly improves the melt flowability of the intermediate layer 11. This is a major processing advantage in a case where the composite structure of the intermediate layer 11 and the plate lid 2 is manufactured by injection molding (that is, in a case of manufacturing by injection bonding). Specifically, even in a case where a mold having a long moving distance from a molten resin gate is used, it is possible to obtain a composite structure having a high bonding strength effectively and with good reproducibility.

Examples of the acid-modified polymer include a polymer containing a carboxylic acid and/or a carboxylic acid anhydride group. As the acid-modified polymer, an acid-modified polyolefin resin containing a skeleton derived from an olefin component and an unsaturated carboxylic acid component is preferably used. Examples of commercially available acid-modified polymers include Nucrel (registered trademark) series, which is an acid-modified polyolefin resin manufactured by Mitsui-Dupont Polychemicals Co., Ltd., Himilan (registered trademark) series, which is an ionomer resin thereof, Kurarity (registered trademark) series, which is an acrylic-based block copolymer manufactured by Kuraray Co., Ltd., Modic (registered trademark) series, which is an acid-modified polyolefin resin manufactured by Mitsubishi Chemical Corporation, Admer (registered trademark) series, which is an acid-modified polypropylene manufactured by Mitsui Chemicals, Inc., Rexpearl (registered trademark) series, which is an acid-modified polyethylene resin manufactured by Japan Polyethylene Corporation, Bondine (registered trademark) series, which is a maleic anhydride-modified polyolefin resin manufactured by Arkema, and the like.

As another example, the intermediate layer 11 may be a light-absorbing resin member.

For example, in a case where the box body 3 is light transmissive, (1) first, the plate lid 2, the intermediate layer 11, and the box body 3 are stacked in this order from the bottom up (at this time, the opening portion of the box body 3 is directed downward), and (2) next, by irradiating the intermediate layer 11 with an appropriate laser light through the box body 3, the intermediate layer 11 generates heat and it is possible to bond (weld) the intermediate layer 11 and the box body 3 and/or the intermediate layer 11 and the plate lid 2.

In a case where the intermediate layer 11 is a light-absorbing resin member, the intermediate layer 11 includes, for example, a thermoplastic resin and a light absorber.

Examples of the thermoplastic resin include the thermosetting resins listed in the description of the fiber-reinforced resin and/or the resin containing an inorganic particle filler in the first embodiment.

Examples of light absorbers include colored pigments, dyes, and the like. Examples of colored pigments include black pigments such as carbon black, red pigments such as iron oxide red, white pigments such as titanium oxide, various types of organic pigments, and the like.

In addition, the light absorber may be a laser light-absorbing dye having an absorption wavelength in the wavelength range of the laser light to be irradiated. Examples of laser light-absorbing dyes include nigrosine, aniline black, phthalocyanine, naphthalocyanine, porphyrin, perylene, quaterylene, azo dyes, anthraquinone, squaric acid derivatives, immonium, and the like. A particularly preferable laser light-absorbing dye is nigrosine. Nigrosine is a black azine-based condensation mixture.

In a case where the intermediate layer 11 includes a light absorber, only one type of light absorber may be included or two or more types of light absorber may be included.

In a case where the intermediate layer 11 includes a light absorber, the content of the light absorber in the intermediate layer 11 is preferably 0.01% by mass to 5% by mass when the entire intermediate layer 11 is 100% by mass.

The thickness of the intermediate layer 11 is, for example, 0.1 mm to 10 mm, and preferably 0.2 mm to 5 mm.

### <Fourth Embodiment>

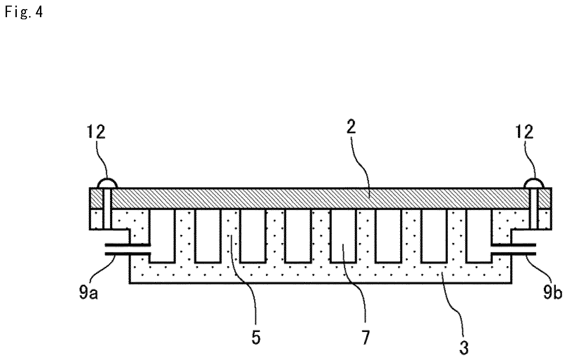

Fig. 4 is a schematic diagram (schematic cross-sectional diagram) to illustrate the structure of the cooling unit of the fourth embodiment.

The cooling unit of the fourth embodiment differs from the cooling unit of the first embodiment in that the plate lid 2 and the box body 3 are fixed using screws 12. Fixing with the screws 12 makes it possible to further reduce the possibility of refrigerant leakage.

The screws 12 may be fixing members other than screws, such as rivets.

Normally, the end portion of the box body 3 and the end portion of the plate lid 2 are screwed together with the screws 12. The number of the screws 12 and the positions of the screws are not particularly limited.

In the cooling unit of the fourth embodiment, the plate lid 2 and the box body 3 are bonded by at least the screws 12, but the bonding by the screws 12 may be combined with bonding by other methods. For example, bonding with an adhesive and bonding with the screws 12 may be combined.

### <Fifth Embodiment>

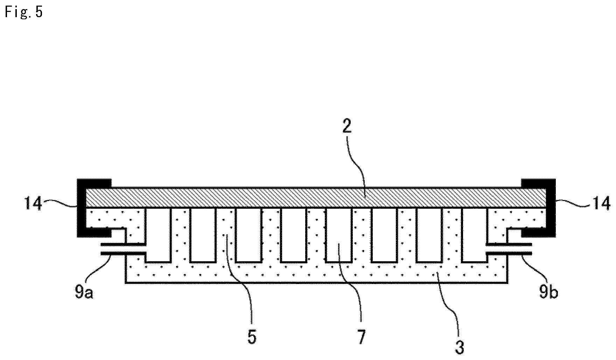

Fig. 5 is a schematic diagram (schematic cross-sectional diagram) to illustrate the structure of the cooling unit of the fifth embodiment.

The cooling unit of the fifth embodiment is different from the cooling unit of the first embodiment in that a resin sealing member 14 is provided so as to cover the bonding portion between the plate lid 2 and the box body 3 (in particular, the periphery/edge thereof) . With the resin sealing member 14, it is possible to further reduce the possibility of refrigerant leakage.

The material forming the resin sealing member 14 is not particularly limited. For example, it is possible to provide the resin sealing member 14 using the fiber-reinforced resin and/or resin containing an inorganic particle filler described above, resin which is neither a fiber-reinforced resin nor a resin containing an inorganic particle filler, various elastomers, rubber, and the like. The thickness and the like of the resin sealing member 14 are not particularly limited as long as there is an effect of reducing refrigerant leakage.

### <Sixth Embodiment>

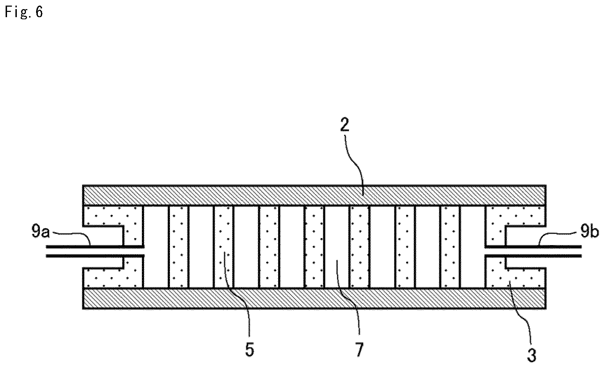

Fig. 6 is a schematic diagram (schematic cross-sectional diagram) for illustrating the structure of the cooling unit of the sixth embodiment.

In the cooling unit of the sixth embodiment, both the upper surface and lower surface of the box body 3 are open. The plate lid 2 is bonded with the box body 3 so as to block the opening on the upper surface and the plate lid 2 is bonded with the box body 3 so as to block the opening on the lower surface. In these respects, the cooling unit of the sixth embodiment is different from the cooling unit of the first embodiment.

Since both surfaces of the upper surface and lower surface of the box body 3 are the plate lids 2, it is possible to install objects to be cooled on both surfaces. In this manner, it is possible to make the cooling unit and the object to be cooled compact overall.

### <Cooling Apparatus, Battery Structure, and Electric Vehicle>

it is possible to obtain a cooling apparatus by thermally connecting one or more objects to be cooled to the upper surface of the plate lid 2 of the cooling unit as described above. For example, in a case where the object to be cooled is a battery block, the cooling apparatus as a whole is a battery structure.

Part or an entirety of the cooling apparatus may be covered by a suitable housing.

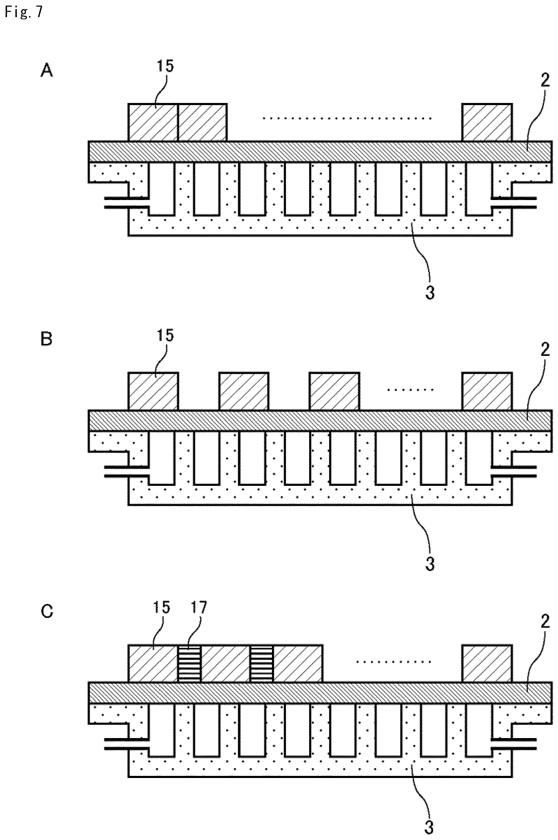

Fig. 7A, Fig. 7B, and Fig. 7C are diagrams schematically representing a cooling apparatus with an object to be cooled 15 thermally connected to the upper surface of the plate lid 2 of the cooling unit of the first embodiment, respectively.

The object to be cooled 15 is not particularly limited.

Examples thereof include an electronic component (for example, a central processing unit (CPU), power semiconductor, or the like), a lamp, a battery, a superconducting material, and the like.

Description will continue below of Fig. 7A, Fig. 7B, and Fig. 7C, in which the object to be cooled 15 is a battery cell 15 and the battery cell 15 and the cooling unit as a whole form a battery structure.

In Fig. 7A, two or more of the battery cells 15 are arranged closely to each other to form a battery block. Each of the battery cells 15 is, for example, a lithium-ion battery such as a lithium-ion secondary battery.

The battery cells 15 are, for example, rectangular, cylindrical, or pouch-shaped (the same applies in Fig. 7B and Fig. 7C). Typically, the flat portion of the rectangular, cylindrical or pouch-shaped battery cell is thermally connected to the upper surface of the plate lid 2.

The end portions of the battery cells 15 in the array direction are preferably provided with end plates (not shown) to prevent shifting or the like of the battery cells 15 (the same applies in Fig. 7B and Fig. 7C).

A heat conductive sheet (not shown) is preferably present between the upper surface of the plate lid 2 and the lower surface of the battery cell 15. Alternatively, instead of a heat conductive sheet, a substance called a thermal interface material (TIM) may be used. Specific examples of TIM include thermal grease, a phase change material (PCM), gel, a high heat conductive adhesive, thermal tape, and the like.

In Fig. 7B, two or more of the battery cells 15 are arranged at intervals from each other to form a battery block. In other words, in Fig. 7B, the two or more of the battery cells 15 are arranged such that voids are generated between the adjacent battery cells 15. The presence of the voids may be preferable in order to make air cooling possible in addition to cooling by the refrigerant.

In Fig. 7B, it is also preferable to have a heat conductive sheet or TIM (not shown) present between the upper surface of the plate lid 2 and the lower surface of the battery cells 15.

In Fig. 7C, spacers 17 are interposed between two or more of the battery cells 15. For example, in a case where the battery cells 15 are pouch-shaped, reinforcement with the spacers 17 is preferable in order to reinforce the weakness of the trunk sections in a case where the battery cells are standing up.

The spacers 17 may also combine the function of a cooling fin. In such a case, usually, the material of the spacers 17 (cooling fins) is preferably the same type of material as the plate lid 2. The spacers 17 (cooling fins) and the plate lid 2 may be formed separately or may be formed integrally.

Also, in Fig. 7C, a heat conductive sheet or TIM (not shown) is preferably present between the upper surface of the plate lid 2 and the lower surface of the battery cell 15. In addition, in a case where the spacers 17 (cooling fins) and the plate lid 2 are formed separately, a heat conductive sheet or TIM (not shown) is also preferably present between the upper surface of the plate lid 2 and the spacers 17 (cooling fins).

The cooling apparatus may be provided with a sensor (not shown in Fig. 7A, Fig. 7B, and Fig. 7C) which senses refrigerant leakage from the bonding interface between the plate lid 2 and the box body 3. The sensor is preferably provided with a unit for wired or wireless connection to a leak detection module which notifies users and/or administrators of the cooling apparatus of abnormalities. Due to this, in a case where refrigerant leaks from the cooling unit for some reason, the influence of the leak is minimized.

The battery structure as shown in Fig. 7A, Fig. 7B, or Fig. 7C, which may be alone or two or more connected structures, may be covered by a housing (a housing is not shown in Fig. 7A, Fig. 7B, and Fig. 7C). Covering with a housing improves the functions of being waterproof, dustproof, impact resistant, and the like. The material, form, formation method, and the like of the housing are not particularly limited. An appropriate material, form, formation method, and the like may be selected based on the cost, heat resistance, durability, or the like. The housing may cover the entire battery structure (cooling apparatus) or may cover only a part of the battery structure (cooling apparatus).

The battery structure covered by the housing may be used, for example, as a power source for electric vehicles. Specifically, it is possible to mount the battery structure covered by the housing under the floor of an electric vehicle, as a power source for an electric vehicle, such as an electric automobile.

Embodiments of the present invention were described above, but these are examples of the present invention and it is possible to adopt various other configurations. In addition, the present invention is not limited to the embodiments described above and variations, improvements, and the like are included in the present invention in a range in which it is possible to achieve the purpose of the present invention.

This application claims priority based on Japanese Unexamined Patent Publication No. 2019-062787, filed on March 28, 2019, and the entirety of the disclosure is incorporated herein.

### REFERENCE SIGNS LIST

- 2:: plate lid
- 3:: box body
- 5:: flow path-forming rib
- 7:: flow path
- 9a:: refrigerant inlet
- 9b:: refrigerant outlet
- 11:: intermediate layer
- 12:: screw
- 14:: resin sealing member
- 15:: object to be cooled (battery cell)
- 17:: spacer

## Claims

1. A cooling unit comprising:
a structure in which a box body made of resin and a plate lid made of metal are bonded together,
wherein at least one of an upper surface and a lower surface of the box body has an opening and the plate lid is bonded with the box body so as to block the opening,
a wall surface of the box body is provided with a refrigerant inlet and a refrigerant outlet for allowing a refrigerant to flow in the box body,
a flow path-forming rib is provided in the box body, and
a part or an entirety of the box body is formed of a fiber-reinforced resin and/or a resin containing an inorganic particle filler.

2. The cooling unit according to claim 1,
wherein a fiber included in the fiber-reinforced resin are at least one selected from the group consisting of a carbon fiber, a glass fiber, a potassium titanate fiber, an aluminum borate fiber, a ceramic fiber, a metal fiber, a boron fiber, a silicon carbide fiber, an asbestos fiber, a rock wool fiber, an aramid fiber, a polyethylene fiber, a polypara-phenylene benzobisoxazole fiber, and a cellulose fiber, and
the inorganic particle filler is at least one selected from the group consisting of mica, talc, and glass flakes.

3. The cooling unit according to claim 1 or 2,
wherein the flow path-forming rib is integrally molded with the box body.

4. The cooling unit according to claim 1 or 2,
wherein the flow path-forming rib is formed separately from the box body by a resin which is neither a fiber-reinforced resin nor a resin containing an inorganic particle filler and bonded in the box body formed of the fiber-reinforced resin and/or the resin containing an inorganic particle filler.

5. The cooling unit according to claim 4,
wherein a part of the flow path-forming rib covers an upper end portion of the box body in a flange shape and the plate lid is bonded with the box body through a flange shaped portion of the flow path-forming rib.

6. The cooling unit according to any one of claims 1 to 5,
wherein the metal forming the plate lid is at least one selected from the group consisting of aluminum, copper, magnesium, and an alloy thereof.

7. The cooling unit according to any one of claims 1 to 6,
wherein a fine uneven structure and/or a thin film layer containing a functional group is formed on a bonding surface of the plate lid with the box body.

8. The cooling unit according to claim 7,
wherein an average pore diameter of a concave portion in the fine uneven structure is 5 nm to 250 µm and an average pore depth of the concave portion is 5 nm to 250 µm.

9. The cooling unit according to claim 7 or 8,
wherein the functional group is at least one selected from the group consisting of a hydroxyl group, a silanol group, a mercapto group, a thiocarbonyl group, a cyano group, an isocyanate group, an amino group, an ammonium group, a pyridinium group, an azinyl group, a carboxyl group, a benzotriazole group, and a triazinethiol group.

10. The cooling unit according to any one of claims 1 to 9,
wherein the box body and the plate lid are directly bonded with each other without an intermediate layer.

11. The cooling unit according to any one of claims 1 to 9,
wherein the box body and the plate lid are bonded with each other through an intermediate layer.

12. The cooling unit according to any one of claims 1 to 11,
wherein the box body and the plate lid are fixed by a rivet and/or a screw.

13. The cooling unit according to any one of claims 1 to 12,
wherein a resin sealing member is provided so as to cover a bonding portion between the box body and the plate lid.

14. A cooling apparatus comprising:
the cooling unit according to any one of claims 1 to 13; and
an object to be cooled that is thermally connected to an upper surface of the plate lid of the cooling unit.

15. The cooling apparatus according to claim 14,
wherein the object to be cooled is at least one selected from the group consisting of an electronic component, a lamp, a battery, and a superconducting material.

16. The cooling apparatus according to claim 14 or 15, further comprising:
a sensor for sensing leakage of a refrigerant from a bonding interface between the box body and the plate lid,
wherein the sensor is provided with a unit for wired or wireless connection to a leak detection module for notifying a user and/or an administrator of the cooling apparatus of an abnormality.

17. A battery structure comprising:
a battery block in which two or more battery cells are arranged adjacent to each other in close contact or at an interval; and
the cooling unit according to any one of claims 1 to 13,
wherein the battery block is arranged on the plate lid in the cooling unit.

18. An electric vehicle comprising:
the battery structure according to claim 17,
wherein the battery structure is covered by a housing, either as one battery structure or two or more connected battery structures.
